# EUROPEAN PATENT APPLICATION

(11) **EP 0 524 422 A2**
(43) Date of publication of application: **27.01.1993**
(21) Application number: 92110053.3
(22) Date of filing: 15.06.1992
(51) Int. Cl.: C23C 18/48, C23C 18/52

(54) **Tin lead treatment**

(30) Priority: 22.07.1991 US 733705
(71) Applicant: SHIPLEY COMPANY INC., Newton, Massachusetts 02162 (US)
(72) Inventor: Shipley, Charles R., Newton, Massachusetts 02166 (US); Staniunas, Richard, Northboro, Massachusetts 01532 (US)
(74) Representative: Bunke, Holger, Dr.rer.nat. Dipl.-Chem.

(57) **Abstract**

A process for increasing the reflow capability of a tin lead alloy deposit and increasing its adhesion to an underlying substrate, said process comprising impregnating a tin lead immersion deposit with tin prior to reflow. The process is useful in the manufacture of printed circuit boards.

## Description

### Background of the Invention

### 1. Introduction

This invention relates to immersion solder deposition and more particularly, to treatment of an immersion solder deposit to enhance its reflow capability, to increase its adhesion to an underlying substrate and in certain instances, to eliminate the requirement for reflow. The invention is especially useful for the manufacture of printed circuit boards.

### 2. Description of the Prior Art

Tin lead alloy having a composition of between 60 and 65 percent tin and 35 to 40 percent lead (solder) is coated onto copper traces in the manufacture of printed circuit boards. The alloy may function as an etch resist and permits attachment of components to a circuit board. For this latter use, the alloy must melt and reflow at a reasonably low temperature to avoid damage to the circuit during heating of the board and must have an adequate thickness for surface mounting of components.

Conceptually, there are four methods available for coating tin lead alloys onto copper traces in printed circuit manufacture. These methods include (1) hot air leveling, (2) electroless plating, (3) immersion plating and (4) electroplating. Each coating process has advantages and disadvantages and the metal deposit obtained from each differs from the deposits obtained by other plating methods.

It is known in the art that to be suitable for printed circuit board manufacture, a tin lead alloy deposit over copper circuit lines must be pore free, reasonably thick, should possess a uniform cross section, should be bondable to subsequently attached components and should firmly adhere to the substrate over which it is coated. It is also known that as metal is deposited onto a substrate from solution in a plating process, the deposit obtained is often not coherent and may contain numerous pores due to the nature of the plating reaction. Pores are undesirable as they permit migration of chemicals to the surface of the board during subsequent processing. Pores are eliminated in a tin lead alloy deposit by heating the board with the alloy deposit to a temperature in excess of the alloy's melting point whereby the deposit melts and pores are eliminated by reassembly of the deposit, a process known in the art as "reflow". To reflow a tin lead alloy, the tin lead alloy should melt at a relatively low temperature to avoid damage to the circuit by heating to an excessively high temperature and the deposit must be adequately thick. A thin deposit will not easily reflow and may not contain the minimum mass of metal required to bond a component to a circuit board, particularly if the component is surface mounted on the board. Difficulty in relowing thin deposits may be due to the deposit containing intermetallic compounds on its surface. To obtain a low melting tin lead alloy, the deposit desirably has a concentration of tin and lead at or close to the low melting eutectic of tin and lead (approximately 63% tin and 37% lead by weight - i.e., solder).

Electrolytic plating of tin lead alloys is disclosed by Schlabac and Ryder, Printed and Integrated Circuitry, McGraw Hill Book Company, Inc., New York, 1963 at page 146. Electrolytic plating of tin lead alloys is one method of choice in the industry but suffers certain disadvantages. For example, for electrolytic deposition, a circuit board must be racked as part of an electrolytic cell which is labor intensive. In addition, due to uneven current densities as a consequence of a circuit pattern over which the tin lead alloy is to be deposited, throwing power of the electrolytic bath does not provide desired uniformity and deposits of uneven thickness are obtained. This problem is aggravated if the circuit board is one having high aspect ratio through holes. Further, deposits of a 60/40 percent tin lead alloy, the alloy of choice, requires close control of the solution composition and operating conditions of the electrolytic cell. Finally, once the tin lead alloy is coated onto the circuit, and the copper not coated with the alloy is etched, the resultant copper circuit traces are discontinuous and damaged circuits are not readily reworked because electrolytic deposition cannot take place over a discontinuous conductive substrate.

Hot air leveling is also conventionally used in the art to provide a tin lead deposit over copper circuit lines. In this process, the circuit board is floated or immersed in a molten tin lead bath. The molten coating obtained is of non uniform thickness and is then made more uniform by passing the board with the tin lead coating beneath a stream of hot air to level the coating. Notwithstanding the use of the hot air stream, the coating obtained is thin at the heel of the hole and non uniform and with high aspect ratio holes, thin in the center of the hole. If a circuit contains blind vias, hot air leveling may not be suitable due to the via becoming blocked during the process.

Electroless plating baths for each of tin and lead, separately, are known in the art. For example, an electroless tin plating bath is disclosed by Warwick and Shirley, The Autocatalytic Deposition of Tin, Trans. Inst. Met. Fin. 58 9 (1980) pp. 9-14 and by Juergen, Chemical Deposition of Tin and Tin Lead, European Institute of Printed Circuits, Deposition for PCB; Conference: Economics and Cost Savings, Conference location: Munich, West Germany, Conference Date: 1983, Monthly number: EIM8506-033415, 1983. A publication showing the electroless codeposition of tin and lead is not known. It is believed that electroless solder plating baths are difficult to formulate because an autocatalytic solution must contain a mixture of tin and lead as well as a complexing agent and reducing agent for each in a single plating solution.

Immersion plating is an electroless plating process, but is given separate classification. In immersion plating, deposition is by displacement of elemental metal from a substrate by metal ions in a plating solution while in electroless plating, plating takes place primarily by autocatalytic reduction of metal ions from solution.

Since immersion plating is by displacement, immersion plating is an electrochemical reaction that depends upon the position the substrate metal occupies in the electromotive series relative to the metal to be deposited from solution. Plating occurs when the metal from a dissolved metal salt is displaced by a more active (less noble) metal immersed in the solution. Since copper is more noble than tin or lead, copper should not be plated by an immersion process to give a tin lead deposit. However, when complexed under acidic conditions, the electropotentials of the tin and lead complexes relative to copper reverse making immersion plating possible. However, limitations in the use of immersion plating for circuit fabrication exist. These include a slow plating rate, difficulty in obtaining a desired alloy and limited deposit thickness. Limited thickness is due to the plating reaction being self limiting because as the coating builds, the metal deposited from solution masks the underlying base metal which functions as the reducing agent and is required for displacement. Additionally, as the displaced base metal is dissolved in solution, it becomes a contaminant progressively slowing the rate of displacement. Typical deposit thickness for an immersion tin deposit in the prior art is 50 to 100 microinches, mainly because of the foregoing problems.

Absent the above disadvantages, there would be advantages to immersion plating compared to other methods for depositing tin lead alloy in circuit manufacture. Compared to electroless and electroplating, there is no hydrogen generation during the plating process and no concomitant pitting or other discontinuities in the deposit. Also, immersion plating is not subject to surface roughness as found in electroplating processes due to "drag-over" from precleaners, anode corrosion and the like. Further, since electroless baths contain both a metal to be plated and a reducing agent, the bath is potentially unstable subject to spontaneous plating. In immersion plating, there is no problem with spontaneous plating. Moreover, with immersion plating, neither an electrically continuous circuit nor attachments of electrical contacts are required nor is there a need to maintain a precise current. Finally, an immersion deposit is generally uniform in thickness and conforms to the underlying topography.

In spite of the potential advantages of immersion plating, the prior art generally dismissed immersion plating processes for printed circuit fabrication because the prior art believed that thick, bondable (solderable) deposits could not be obtained. As stated in Printed and Integrated Circuitry, supra, at page 138, (immersion deposits are) "limited in thickness, porous, and often poorly adherent and, therefore, of limited interest". The self limiting feature and thickness of immersion tin and lead plating procedures were believed to make soldering impossible and consequently, plating baths for immersion deposits of tin and lead were of minimal interest to the art.

In U.S. Patent No. 4,194,913, incorporated herein by reference, an immersion plating composition is disclosed for deposition of tin lead alloys. In accordance with the teachings of this patent, an immersion plating solution is disclosed comprising stannous chloride in an amount of from 10 to 150 grams per liter of solution, lead chloride in an amount of from 1 to 12 grams per liter, sodium hypophosphite in an amount of from 10 to 100 grams per liter, thiourea in an amount of 40 to 100 grams per liter, hydrochloric acid in an amount of from 40 to 100 ml per liter and gelatin in an amount of from 0.1 to 10 grams per liter. In this patent, patentee states that the plating composition of the patent provides a faster plating rate and a deposit of increased thickness compared to that possible using prior art tin lead alloy immersion plating compositions. Though it is believed that improved immersion deposits are obtained using the compositions of said patent compared to those known to the art prior to said patent, the immersion deposits of said patent are believed to be of inadequate thickness, are not readily reflowed and consequently, unsuitable for the commercial manufacture of printed circuit boards.

In European published application No. 0 167 949, also incorporated herein by reference, an immersion tin plating solution that may also contain lead is disclosed as consisting of a tin salt of a fluorine containing mineral acid in an amount of from 1 to 50 grams per liter, a lead salt of a fluorine containing mineral acid in an amount of from 1 to 10 grams per liter, a fluorine containing mineral acid in an amount sufficient to provide a pH varying between 0 and 1, and a sulfur containing complexing agent in an amount of from 10 to 400 grams per liter. Though the application discusses primarily immersion tin plating solutions, an example of a tin lead plating solution is given. However, thick, adherent, reflowable deposits of tin and lead are not obtained from the compositions disclosed in the patent and the compositions are believed to be unsuitable for the commercial fabrication of printed circuit boards.

In copending U.S. Patent Application Serial No. 07/532,819 filed June 4, 1990 assigned to the assignee hereof and incorporated herein by reference, there is disclosed an immersion plating solution capable of plating a thick, porous, adherent tin lead alloy deposit capable of reflow, typically at a temperature of below about 500^{o}F. The invention disclosed in the copending application was based upon a combination of discoveries. For example, one such discovery was that to reflow a tin lead alloy immersion deposit, it was necessary that the deposit be thick and porous - i.e., a deposit having a thickness of at least 100 microinches and preferably at least 150 microinches or greater. Another discovery was the realization that to obtain a thick deposit capable of reflow, it was necessary to utilize a plating solution favoring a porous structure rather than a dense deposit as said to be desired in the prior art. To obtain a thick, porous deposit as required for reflow, an immersion plating solution containing a relatively high metal content was used - i.e., preferably in excess of 0.10 moles per liter of total metal with a tin to lead ratio of at least 1 to 1. Further, both the tin salt and the lead salt, and preferably the acid used to provide a desired pH, all had a fluorine containing anion. In addition, recognizing that the displacement reaction favored tin, a lead promoter was added to solution to maintain a desired concentration of lead relative to tin and to obtain a thick deposit. Finally, to obtain as thick a deposit as possible, exaltants were added to the formulation.

Following deposition of a tin lead alloy from the immersion plating solution described above, the deposit formed had a crystalline porous structure with alternating layers of lead and tin and was capable of reflow by heating to a temperature above the deposit melting point for a time sufficient to form a dense coherent coating. After reflow, the alloy was dense and shiny and believed to be a true homogeneous alloy of tin and lead.

The immersion deposition composition of the copending application provided solder alloys suitable for the manufacture of printed circuit boards. However, as should be evident from the discussion set forth above, the solution required operation within restricted concentrations and conditions to obtain deposits suitable for reflow. Moreover, it has been found that as the solution was used, adhesion between the deposit from solution and the underlying substrate decreased.

### Summary of the Invention

The present invention provides a process for improving the reflow capability of tin-lead immersion deposits, for increasing the adhesion of such a deposit to its underlying substrate over the full useful life of the solution from which it is plated and in some instances, eliminating the need for reflow. In the prior art, reflow of a tin-lead immersion deposit could be accomplished only if the deposit was plated from a limited class of coating compositions and only when the deposit had certain physical and chemical characteristics, i.e., thick and porous. In addition, such deposits were often characterized by poor adhesion to its underlying substrate when the deposit was plated from a solution that had been in use for a prolonged period of time. In contrast, in accordance with the process of the present invention, tin-lead immersion deposits are more easily reflowed or reflow may be eliminated, and the deposit strongly adheres to its underlying substrate regardless of the age of the solution from which it is plated. Accordingly, immersion deposits and compositions used to form immersion deposits need not be so carefully selected and controlled to obtain reflow capability.

The process of the present invention is characterized by a post treatment step of tin deposition over a tin-lead immersion deposit. Though not wishing to be bound by theory, it is believed that reflow is inhibited by oxidation occurring at the copper-immersion deposit interface or by formation of copper tin intermetallic compounds, particularly need the interface of the deposit with the atmosphere. It is further believed that deposition of tin inhibits oxide formation or formation of deleterious intermetallic compounds.

### Description of the Preferred Embodiments

In accordance with the invention disclosed herein, an immersion tin lead alloy is deposited on a substrate in conventional manner using pretreatment steps and deposition procedures known in the art or a novel deposition sequence as disclosed herein. The immersion deposit is preferably deposited to a thickness in excess of 100 microinches to assist reflow following the procedures of this invention. The preferred immersion deposit is plated from plating solutions such as those disclosed in copending U.S. Patent Application 07/532,819 referenced above though following the procedures of this invention, immersion tin lead deposits can be made to reflow from other immersion plating solutions as will be disclosed below.

Preferred tin lead alloy plating solution for use in the process of the invention as disclosed in copending U.S. Patent Application 07/532,819 has the following composition:

**TABLE I**

| Component | Broad Range | Preferred Range |
|---|---|---|
| Sn⁺⁺ | 0.05 to 0.50 moles/liter | 0.10 to 0.30 moles/liter |
| Pb⁺⁺ | 0.01 to 0.15 moles/liter | 0.02 to 0.10 moles/liter |
| Sn⁺⁺ + Pb⁺⁺ | 0.05 to 0.60 moles/liter | 0.10 to 0.35 moles/liter |
| Ratio Sn⁺⁺:Pb⁺⁺ | 1.0:3.0 to 50.0:1.0 | 1.0:1.0 to 10.0:1.0 |
| Complexing agent | 0.05 to 2.50 moles/liter | 0.50 to 2.00 moles/liter |
| Lead Promoter | 0.00 to 0.60 moles/liter | 0.05 to 0.25 moles/liter |
| pH controller | to pH 1.5 | to 1.2 |
| Thickness promoter | 0.00 to 1.00 moles/liter | 0.001 to 0.20 moles/liter |
| Buffer | to maintain pH | to maintain pH |
| Water | to 1 liter | to 1 liter |

The stannous and plumbous ions are provided to the bath in the form of a solution soluble salt, preferably of a fluorine containing acid. Suitable sources of the salt include tin flourides, fluoroborate or fluorosilicates. Preferred sources for both are their respective fluoroborate salts. The concentrations of tin and lead in solution are given in Table I. These concentrations are believed to be high compared to that which are known in the art. The high concentration contributes to a rapid rate of deposition and a porous deposit having a thickness prior to reflow of at least 100 microinches. A thick deposit promotes reflow and is desirable for surface mounting of components to the board. The ratio of the tin to lead ions is also given in Table I. This ratio permits deposition of alloys with tin ranging between 50 and 82 percent and lead ranging between 50 and 18 percent. The preferred solutions deposit alloys with tin ranging between about 56 and 74 percent and lead ranging between 44 and 26 percent.

The plating solutions contain a complexing agent in an amount at least sufficient to complex all of the metal in solution and preferably in an amount in excess of the amount required for complete complexation of all metal present in solution. The broad and preferred ranges for the concentration of the complexing agent are given in Table I. The complexing agent used is one preferably capable of complexing both tin and lead ions. Sulfur containing complexing agents are preferred, especially compounds containing sulfur and nitrogen such as thiourea or a substituted thiourea such as one having allyl substitution or substitution with a lower alkyl group having from 1 to 4 carbon atoms such as tetramethyl thiourea.

Tin plates from solution preferentially to lead. To avoid deposition of an alloy with an undesirably high tin content, a component is added to the plating solution that promotes the rate of lead deposition relative to tin by changing the displacement potential of each. Suitable lead promoters include hypophosphorus acid, sodium hypophosphite, glycerin, urea, amino acetic acid, etc. Hypophosphorous acid and sodium hypophosphite are preferred. The concentration of the lead promoter is given in Table I. Though ranges are given, the relative rate of codeposition of tin and lead is subject to variables such as solution pH, solution temperature and the total combined metals content of the solution.

The immersion plating solutions are acidic and have a pH between about 0.2 to 2.0. Any solution compatible acid may be used to acidify the solution, but desirably, the acid has an anion common to the acid salts of tin and lead. Therefore, fluorine containing acids such as hydrofluoric acid, fluoroboric acid and fluorosilic acid are suitable with fluoroboric acid being most preferred.

A thickness promoter is used in the immersion plating solution. Solution soluble salts of a metal of the Group IVb, Vb or VIb of the periodic table of the elements are suitable. Such metals include molybdenum, zirconium, titanium, chromium, vanadium, etc. Titanium added in the form of titanium trichloride dissolved in hydrochloric acid constitutes a preferred thickness promoter. The titanium ion concentration is given in Table I.

Chloride ion is another desirable additive in solution to promote deposit thickness. The chloride ion concentration preferably varies between 0 and 0.5 moles per liter and more preferably, between 0.0001 and 0.20 moles per liter.

An additional desirable component in the solution is a fluorine containing acid, and preferably flouroboric acid in minor amount sufficient to provide the required pH as set forth in Table I.

Another immersion tin lead immersion deposit that can be made to reflow in deposits in excess of 100 microinches following the procedures of this invention is disclosed in Re. 30,434 reissued Nov. 11, 1980 incorporated herein by reference. A preferred immersion depositing solution, in accordance with this patent, comprises stannous chloride in a preferred amount of from 20 to 40 grams per liter, lead chloride in an amount of from 2 to 15 grams per liter, sodium hypophosphite in an amount of from 10 to 100 grams per liter, thiourea in an amount of from 40 to 100 grams per liter, hydrochloric acid in an amount of from 40 to 100 grams per liter and gelatin in an amount of from 1 to 4 grams per liter.

The immersion plating solutions are used in conventional manner or in accordance with a novel process disclosed herein. A substrate having a cupreous surface is prepared for deposition by cleaning and etching the cupreous metal with an etchant such as a sodium persulfate - sulfuric acid etchant or an ammonium bifluoride - hydrogen peroxide etchant. Thereafter, following procedures believed not to be known to the art, the substrate is then treated with a buffer solution which contains components common to those contained in the immersion plating solution to maintain pH, to maintain certain components within a desired concentration range and to prevent drag in of undesirable components into the immersion plating solution. For example, the buffer solution may contain complexing agents, a lead promoter, pH adjustors, thickness promoters, buffers, etc. After treatment with the buffer solution, the substrate is then contacted with the immersion plating solution, preferably without an intermediate water rinse.

The substrate is then immersed in the immersion plating solution for a time sufficient to form a tin lead deposit having a thickness of at least 100 microinches and preferably ranging between 150 and 350 microinches. Typically, the plating time required to obtain such a deposit is between about 5 and 30 minutes. As is known in the art, plating temperature affects the rate of deposition and deposit thickness. Plating temperatures typically range from about room temperature to close to the boiling point of the plating solution but temperatures of from about 100^{o}F to about 175^{o}F are typical.

Using the plating solutions of the copending application referenced above, the deposits formed are porous and matte gray in color with an observable sparkle dispersed throughout the deposit. Deposits having the visible sparkle are readily reflowed. The deposits are non homogeneous and are known to be layered.

The next step in the process comprises deposition of tin over the tin lead alloy immersion deposit. Deposition of tin may be by any method known to those skilled in the art and formulations for depositing tin are disclosed in the literature. For example, immersion deposition of tin is disclosed in U.S. Patents Nos. 3,303,029; 4,234,631; 4,657,632; and 4,882,202, all incorporated herein by reference. An electroless method for depositing tin is disclosed in U.S. Patent No. 4,269,625, incorporated herein by reference. An electroplating formulation for depositing tin as well as tin lead alloys is disclosed in U.S. Patent No. 4,599,149, incorporated herein by reference. Of the various methods known to the art for depositing tin on a substrate, immersion deposition is preferred and those immersion depositing solutions disclosed in U.S. Patent No. 3,303,029 are most preferred. A typical formulation for immersion deposition

of tin in grams is set forth below.

### Example 1

| | |
|---|---|
| Stannous fluoroborate | 148.2 |
| Thiourea | 166.6 |
| Hypophosphorus acid | 50.0 |
| Phenol sulfonic acid | 16.0 |
| Wetting agent and surfactants | 32.9 |
| Water | to make 1 liter. |

The above formulation can be operated at any temperature at which the tin complex remains soluble such as from about room temperature up to about the boiling point of the solution. A preferred temperature ranges from 135^{o}F to about 160^{o}F. Time of treatment can be from 30 seconds up to 30 minutes though shorter deposition times are preferred unless it is desired to eliminate reflow in which case longer deposition times with thick immersion deposits are preferred. Most preferably, if the intent is to eliminate reflow as a processing step, then deposition of tin should continue until the pores of the immersion alloy deposit are filled with the tin.

It is unexpected that tin would immersion plate over an immersion deposit of tin and lead. The reason for this is that immersion plating involves displacement. Where the tin lead alloy has been deposited over copper, it would be expected that copper would not be available for additional displacement when a part is immersed in an immersion tin depositing solution. However, especially with the preferred tin lead immersion compositions, the deposit is porous and it is believed that the tin is able to penetrate the pores and deposit throughout the coating including at the interfaces with the air and substrate.

The step of depositing tin may take place at any time subsequent to formation of the immersion tin lead deposit though the manner in which the deposit is to be used may dictate the preferred time of deposition. For example, if the immersion tin-lead alloy is deposited from an aged immersion depositing solution that has been in use for one half cycle or more, the adhesion between the deposit and the underlying substrate is likely to be poor and it is desired that tin deposition take place promptly following deposition of the immersion deposit. Similarly, if the deposit is to be used without reflow, again it is desired that the tin deposition take place soon after immersion deposition of the alloy. Otherwise, it is preferred that the tin be deposited close to the time of reflow. In this respect, it is not uncommon in the industry to deposit solder and then to store the part for several days or more prior to reflowing the solder.

Following deposition of tin, the immersion tin lead deposit may be reflowed in conventional manner. Reflow involves heating the alloy above its melting point and holding the alloy at this temperature for a short period of time, typically for less than one minute. A preferred method involves floating or immersing a part with the tin lead and tin deposits on hot oil. Prior to reflow, the part is preferably warmed and following reflow, the part is preferably quenched at elevated temperature, all in accordance with conventional practice in the art. It is a characteristic of the tin lead deposit that deposits having a thickness of less than about 100 microinches are difficult to reflow. In addition, it is believed that prior to the invention disclosed herein and that of the copending application referenced above, immersion deposits of lead and tin which were capable of reflow were not in commercial use and may not have been known in the art.

The invention will be better understood by reference to the examples that follow:

### Example 2

This example is set forth for purposes of comparison. For this example, Solderposit™ 9050 available from Shipley Company Inc. of Newton, MA was used. This formulation contains stannous fluoroborate, plumbous fluoroborate, fluoboric acid, thiourea, a lead promoter and a thickness promoter and is formulated to provide an immersion alloy deposit having a tin and lead composition about that of the solder eutectic. This depositing formulation is more fully described in the above referenced copending patent application. The formulation is used at a pH of 0.8 and at a plating temperature of 71^{o}C.

Copper clad epoxy glass laminate was prepared for plating by immersion in an acid soak cleaner followed by immersion in a mild copper etching solution and a fluoroboric acid soak with rinsing after each treatment except for the fluoroboric acid soak. A part was then immersed into the aforesaid plating solution for a period of ten minutes. The deposit thickness of was determined and the deposit reflowed by fluxing, warming at 250^{o}F in oil for about 20 seconds, reflowed in hot oil at 400^{o}F for 20 seconds and quenched in oil at 250^{o}F. Parts were then rinsed, cleaned and dried. Deposit thickness was found to be about 200 microinches, the deposit had a light matte grey appearance with a slight sparkle and a tin content of 67 percent and a lead content of 33 percent.

### Example 3

The procedure of Example 2 was repeated, but this time the coated substrate was stored open to the environment for six months. When IR reflow was attempted, some delamination occurred, the reflowed deposit was nodular, there was evidence of dewetting and the deposit was irregular. Repetition of the procedure with inclusion of a step of immersion deposition of tin from a tin plating solution such as that of Example 1 for 1 minute resulted in reflow of the deposit in a manner similar to that of Example 2.

### Example 4

The procedure of Example 2 was repeated after the bath had been used to process about 300 square feet of copper clad laminate. Following deposition, the deposit readily peeled from the substrate. Repetition of the procedure with inclusion of a step of immersion deposition of tin from a tin plating solution such as that of Example 1 for 1 minute resulted in a tin coated deposit strongly adhered to the underlying substrate.

## Claims

1. A process for improving the reflow capability of an immersion deposit of a tin-lead alloy and improving the adhesion of the alloy to an underlying substrate, said process comprising the steps of providing a metal surface coated with a tin-lead alloy and depositing tin over said tin-lead alloy.

2. The process of claim 1 where the tin lead alloy has a thickness of at least 50 microinches.

3. The process of claim 1 where the tin lead alloy has a thickness of at least 100 microinches.

4. The process of claim 1 where tin is deposited over said tin-lead alloy from an aqueous tin plating solution.

5. The process of claim 3 where the tin plating solution is an immersion tin plating solution.

6. A process for providing a tin-lead deposit on a cupreous substrate, said process comprising the steps of immersing the substrate in a displacement plating solution comprising stannous ions and plumbous ions and thereafter immersing the substrate in a tin plating solution for a time sufficient to deposit an effective amount of tin on the tin-lead deposit.

7. The process of claim 6 including the step of reflowing said deposit into a coherent alloy following immersion of the substrate in a tin plating solution by heating said deposit to a temperature above the melting point of the alloy so formed but below a temperature that would damage the cupreous substrate.

8. The process of claim 7 where the tin lead alloy has a thickness of at least 50 microinches.

9. The process of claim 5 where the tin lead alloy has a thickness of at least 100 microinches and possesses a porous structure.

10. The process of claim 6 where tin is deposited over said tin lead alloy from an aqueous tin plating solution.

11. The process of claim 10 where the tin plating solution is an immersion tin plating solution.

12. The process of claim 6 where the displacement plating solution comprising stannous ions and plumbous ions contains stannous ions in an amount of from 0.05 to 0.50 moles per liter, plumbous ions in an amount of from 0.01 to 0.15 moles per liter, a total content of stannous ions and plumbous ions in an amount of from 0.05 to 0.60 moles per liter and a ratio of stannous ions to plumbous ions varying from about 1.0:3.0 to 50.0:1.0.

13. The process of claim 12 where the displacement plating solution contains stannous ions in an amount of from 0.10 to 0.30 moles per liter, plumbous ions are in an amount of from 0.02 to 0.10 moles per liter, the total content of stannous ions and plumbous ions ranges from 0.10 to 0.35 moles per liter and the ratio of stannous ions to plumbous ions varies from about 1.0:1.0 to 10.0:1.0.

14. The process of claim 12 where the displacement plating solution includes a sulfur containing complexing agent for the stannous ions and plumbous ions in an amount of from 0.50 to 2.50 moles per liter of solution.

15. The process of claim 14 where the complexing agent is thiourea.

16. The process of claim 6 where the tin-lead alloy is plated from an aged plating solution and the tin is deposited immediately following deposition of said alloy.

17. The process of claim 6 where the substrate having the tin-lead alloy is stored for a prolonged time prior to deposition of tin.

18. The process of claim 6 where tin is deposited onto the tin-lead alloy in sufficient quantity to fill all pores in the deposit.

19. An article of manufacture comprising a cupreous substrate plated with a tin lead immersion deposit and a separate tin deposit, said tin-lead deposit having a thickness of at least 50 microinches and a porous structure, said tin deposit being contained at least in part within the pores of said tin lead immersion deposit and the total tin in the combined deposit having a concentration of at least 50 percent by weight.

20. The article of claim 19 where the tin deposit is of a quantity sufficient to fill all pores in the tin-lead immersion deposit.

21. The article of claim 19 where the immersion deposit of tin and lead has a tin content ranging between 56 and 74 percent by weight and a lead content ranging between 44 and 26 percent by weight.

22. The article of claim 21 over a printed circuit board substrate.

23. An article of manufacture comprising the product resulting from heating the article of claim 21 to a temperature above the melting point of the deposit but below a temperature that would damage the cupreous substrate.
